# EUROPÄISCHE PATENTSCHRIFT

(11) **EP 1 798 785 B1**
(45) Veröffentlichungstag und Bekanntmachung des Hinweises auf die Patenterteilung: **05.03.2014**
(21) Anmeldenummer: 06024867.1
(22) Anmeldetag: 01.12.2006
(51) Int. Cl.: H01L 51/00, H01L 51/52

(54) **Transparente polymere Elektrode für elektro-optische Aufbauten**
Transparent Polymer Electrode for Electro-Optical Devices
Electrodes polymériques transparentes pour dispositifs électro-optiques

(30) Priorität: 14.12.2005 DE 102005060159
(43) Veröffentlichungstag der Anmeldung: 20.06.2007
(73) Patentinhaber: Heraeus Precious Metals GmbH & Co. KG, 63450 Hanau (DE)
(72) Erfinder: Elschner, Andreas, 45479 Mülheim (DE); Loevenich, Peter Wilfried, 51061 Köln (DE); Jonas, Friedrich, 52066 Aachen (DE)
(74) Vertreter: Herzog, Martin

(56) Entgegenhaltungen:
- EP-A2- 0 686 662
- WO-A1-2004/114326
- DE-A1- 10 103 416
- DE-A1- 10 335 727
- US-A- 5 719 467
- "BAYTRON P VAP AI 4083 & BAYTRON P VP CH 8000 Product Information for Electronic Grades Designed for Use as Hole-Injection Material in OLEDs" INTERNET CITATION Mai 2001 (2001-05), XP002332032 Gefunden im Internet: URL:http://www.hcstarck-echemicals.com/pdf s/Baytron%20P%20VP%20CH%20800%2 0and%20AI%204083%20Product%20Information.p df [gefunden am 2005-06-15]

## Beschreibung

Die Erfindung betrifft ein Verfahren zur Herstellung transparenter mehrschichtiger Elektroden aus leitfähigen Polymeren, Elektroden hergestellt nach diesem Verfahren und deren Verwendung in elektrooptischen Aufbauten.

Displays auf Basis organischer Leuchtdioden (OLEDs) sind auf Grund ihrer besonderen Eigenschaften eine Alternative zu der etablierten Technologie der Flüssigkristalle (LCD). Insbesondere in Anwendungen portabler, vom Stromfestnetz abgekoppelter Geräte, wie z.B. Mobiltelephone, Pager und Spielzeug, hat diese neue Technologie Vorteile.

Als Vorteile von OLEDs gelten u.a. die extrem flache Bauweise, die Eigenschaft selbst Licht zu erzeugen, d.h. ohne zusätzliche Lichtquelle auszukommen wie bei Flüssigkristallanzeigen (LCDs), die hohe Lichtausbeute und die Blickwinkelfreiheit.

Neben Displays können OLEDs aber auch zum Zweck der Beleuchtung, wie z.B. in Flächenstrahlem, Verwendung finden. Aufgrund ihrer extrem flachen Bauweise lassen sich hiermit sehr dünne Beleuchtungselemente konstruieren, was bisher nicht möglich war. Die Lichtausbeuten von OLEDs übertreffen mittlerweile die von thermischen Strahlern, wie z.B. Glühbirnen und das Emissionsspektrum kann durch geeignete Wahl der Emittermaterialien im Prinzip beliebig variiert werden.

Sowohl OLED-Displays, als auch OLED-Beleuchtungselemente sind nicht auf eine flache starre Bauweise beschränkt. Ebenso lassen sich flexible oder beliebig gekrümmte Anordnungen realisieren, aufgrund der Flexiblität der organischen Funktionsschichten.

Ein Vorteil organischer Leuchtdioden liegt im einfachen Aufbau. Üblicherweise sieht dieser Aufbau folgendermaßen aus: Auf einem transparenten Träger, z.B. Glas oder Kunststofffolie, wird eine transparente Elektrode aufgebracht. Darauf kommt mindestens eine organische Schicht (Emitterschicht) oder ein Stapel nacheinander aufgebrachter organischer Schichten. Zum Schluss wird eine Metall-Elektrode aufgebracht.

Der prinzipiell gleiche Aufbau liegt organischen Solarzellen (OCSs) zugrunde (Halls et al., Nature 1995, 376, 498) nur dass hier umgedreht, Licht in elektrische Energie konvertiert wird.

Der wirtschaftliche Erfolg dieser neuen elektro-optischen Aufbauten wird neben der Erfüllung der technischen Anforderungen wesentlich von den Herstellungskosten abhängen. Vereinfachte Prozessschritte, die zu einer Reduzierung des Herstellungsaufwandes und der Herstellungskosten führen, sind daher von großer Bedeutung.

Als transparente Elektroden in OLEDs oder OSCs werden bisher üblicherweise TCO-Schichten (Transparent Conducting Oxides), wie Indium-Zinnoxid (ITO) oder Antimon-Zinnoxid (ATO) oder dünne Metallschichten verwendet. Die Abscheidung dieser anorganischen Schichten erfolgt durch Sputtern, reaktives Oberflächenzerstäubung (Sputtern) oder thermisches Verdampfen des organischen Materials im Vakuum und ist damit aufwendig und kostenintensiv.

ITO-Schichten sind bei der Herstellung von OLEDs oder OSCs ein wesentlicher Kostenfaktor. ITO-Schichten werden aufgrund ihrer hohen elektrischen Leitfähigkeit bei gleichzeitig hoher Transparenz eingesetzt. Die erheblichen Nachteile von ITO sind jedoch:
a) ITO kann nur in einem aufwendigen, kostenintensiven Vakuumprozess durch (reaktives Sputtern) abgeschieden werden.
b) Beim Abscheideprozess sind Temperaturen von T > 400°C erforderlich, wenn hohe Leitfähigkeiten erzielt werden sollen. Insbesondere die für flexible Displays wichtigen Polymersubstrate halten diesen Temperaturen nicht stand.
c) ITO ist spröde und bildet bei Verformung Risse.
d) Das Metall Indium ist ein begrenzt produzierter Rohstoff und Versorgungsengpässe werden bei weiter steigendem Verbrauch vorhergesagt.
e) Die umweltgerechte Entsorgung von elektrooptischen Aufbauten, die das Schwermetall Indium enthalten, ist ein bisher ungelöstes Problem.

ITO-Schichten werden trotz dieser Nachteile wegen ihres günstigen Verhältnisses von elektrischer Leitfähigkeit zu optischer Absorption und vor allem mangels geeigneter Alternativen weiterhin verwendet. Eine hohe elektrische Leitfähigkeit ist notwendig, um den Spannungsabfall über die transparente Elektrode von stromgetriebenen Aufbauten niedrig zu halten.

In der Vergangenheit wurden Alternativen zu ITO als Elektrodenmaterialien diskutiert, jedoch wurde bisher keine Alternative gefunden, die die vorangehend beschriebenen Nachteile nicht aufweist und gleichzeitig in elektrooptischen Aufbauten vergleichbar gute Eigenschaften liefert.

So wurde polymerer ITO-Ersatz, bei dem Monomere in-Situ auf einem Substrat zu leitfähigen Schichten polymerisiert werden, beschrieben, wie z.B. in-Situ polymerisiertes Poly(3,4-ethylendioxy)thiophen, in der Fachwelt auch kurz als in-situ-PEDT bezeichnet (WO-A 96/08047 und DE 10335727). Diese in-situ-PEDT-Schichten haben allerdings neben der ebenfalls aufwendigen Prozessierung auf dem Substrat, insbesondere für Anwendungen in OLEDs den Nachteil, dass zum einen das Material eine hohe Eigenfärbung aufweist, zum anderen, die hiermit erzielbaren Elektrolumineszenzausbeuten niedrig sind.

Weiterhin wurde als polymerer ITO-Ersatz ein Komplex aus Polyethylendioxythiophen und Polystyrolsulfonsäure, in der Fachwelt auch kurz als PEDT/PSS oder PEDT:PSS bezeichnet, vorgeschlagen (EP-A 686 662, Inganäs et al. Adv., Mater. 2002, 14, 662 - 665; Lee et al. Thin Solid Films 2000, 363, 225 - 228; W.H.Kim et al,. Appl. Phys. Lett. 2002, Vol. 80, No. 20, 3844 - 3846). Die Leitfähigkeit von PEDT:PSS-Schichten aus Formulierungen mit einem PEDT:PSS-Verhältnis wie 1 : 2,5 (Gew.-Anteile) ist allerdings nicht besonders hoch, z. B. ca. 0.1 S/cm für eine wässrige PEDT/PSS-Dispersion (kommerziell als Baytron^{®} P der Firma H.C.Starck erhältlich), und weit vom gewünschten Wert für ITO von 5000-10000 S/cm entfernt. Durch Zugabe von Additiven zu einer solchen wässrige PEDT/PSS-Dispersion wie z.B. Dimethylsulfoxid, N-Methylpyrrolidon, Sorbit, Ethylenglykol oder Glycerin kann zwar die Leitfähigkeit auf ca. 50 S/cm erhöht werden, trotzdem liegt diese aber immer noch deutlich unter dem Wert von ITO. Gegen die Anwendung dieser Schichten als ITO-Ersatz in vielen elektro-optischen Anwendungen spricht darüber hinaus, dass diese Formulierungen aufgrund ihrer groben Teilchenstruktur zu relativ rauen Schichtoberflächen führen. Insbesondere für Anwendungen die empfindlich sind gegenüber Kurzschlüssen aufgrund von Oberflächenrauigkeiten wie OLEDs und OSCs sind diese Schichten daher wenig geeignet.

Es bestand somit weiterhin Bedarf nach einem geeigneten Ersatzmaterial für ITO, welches die Nachteile des ITO nicht aufweist und gleichzeitig in elektrischen bzw. elektrooptischen Aufbauten gleichwertige Eigenschaften liefert.

Aufgabe der vorliegenden Erfindung war es somit, Elektroden herzustellen, die die herkömmlichen ITO-Elektroden ersetzen können, ohne jedoch die vorangehend aufgeführten Nachteile aufzuweisen.

Überraschend wurde nun gefunden, eine in Anspruch 1 definiert, dass Elektroden aus mindestens zwei Elektrodenschichten, wobei die erste Elektrodenschicht aus einer Polythiophendispersion hergestellt wurde, worin 50 Gew.-% der Partikel kleiner als 50 nm sind und auf die eine zweite Schicht enthaltend ebenfalls eine Polythiophendispersion aufgebracht wurde, diese Anforderungen erfüllen.

Gegenstand der vorliegenden Erfindung ist somit ein Verfahren zur Herstellung einer Elektrode wie in den Ansprüchen definiert

Die allgemeine Formel (I) in Anspruch 1 ist so zu verstehen, dass x Substituenten R an den Alkylenrest A gebunden sein können.

Bevorzugt sind Polythiophene enthaltend wiederkehrenden Einheiten der allgemeinen Formel (I) solche enthaltend wiederkehrende Einheiten der allgemeinen Formel (Ia), 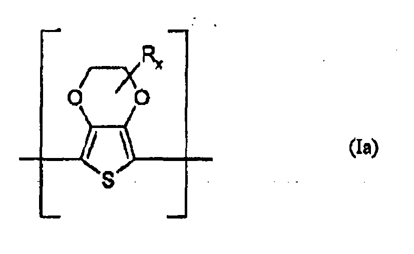 worin
- R und x: die oben genannte Bedeutung haben.

Besonders bevorzugt sind die Polythiophene solche enthaltend wiederkehrende Einheiten der allgemeinen Formel (Iaa)

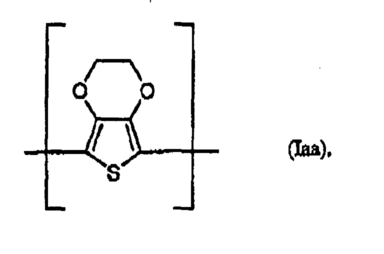

In bevorzugten Ausführungsformen des erfindungsgemäßen Verfahrens sind die Polythiophene solche bestehend aus wiederkehrenden Einheiten der allgemeinen Formeln (Ia) und besonders bevorzugt der allgemeinen Formeln (Iaa).

Unter dem Präfix Poly- ist im Rahmen der Erfindung zu verstehen, dass mehr als eine gleiche oder verschiedene wiederkehrende Einheit im Polymeren bzw. Polythiophen enthalten ist. Die Polythiophene enthalten insgesamt n wiederkehrende Einheiten der allgemeinen Formel (I), wobei n insbesondere eine ganze Zahl von 2 bis 2000, bevorzugt 2 bis 100, sein kann. Die wiederkehrenden Einheiten der allgemeinen Formel (I) können innerhalb eines Polythiophens jeweils gleich oder verschieden sein. Bevorzugt sind Polythiophene mit jeweils gleichen wiederkehrenden Einheiten der allgemeinen Formel (I), bevorzugt der allgemeinen Formeln (Ia) und besonders bevorzugt der allgemeinen Formeln (Iaa).

An den Endgruppen tragen die Polythiophene bevorzugt jeweils H.

In einer besonders bevorzugten Ausführungsform ist das Polythiophen mit wiederkehrenden Einheiten der allgemeinen Formel (I) Poly(3,4-ethylendioxythiophen), d.h. ein Homopolythiophen aus wiederkehrenden Einheiten der Formel (Iaa).

Bevorzugt handelt es sich bei der Dispersion zur Herstellung der ersten Schicht um eine solche, worin 50 Gew.-% der Partikel kleiner als 40 nm, bevorzugt kleiner als 30 nm sind.

Die Partikelgrößenverteilung wird mit einer analytischen Ultrazentrifuge, wie in H.G. Müller; Progr. Colloid Polym Sci 127 (2004) 9-13 beschrieben, bestimmt.

Besonders bevorzugt werden der wässrigen Dispersion zur Herstellung der ersten Schicht, die eines oder mehrere Additive, die die Leitfähigkeit steigern, wie z.B. ethergruppenhaltige Verbindungen, wie z.B. Tetrahydofuran, lactongruppenhaltige Verbindungen wie γ-Butyrolacton, γ-Valerolacton, amid- oder lactamgruppenhaltige Verbindungen wie Caprolactam, N-Methylcaprolactam, N,N-Dimethylacetamid, N-Methylacetamid, N,N-Dimethylformamid (DMF), N-Methylformamid, N-Methylformanilid, N-Methylpyrrolidon (NMP), N-Octylpyrrolidon, Pyrrolidon, Sulfone und Sulfoxide, wie z.B. Sulfolan (Tetramethylensulfon), Dimethylsulfoxid (DMSO), Zucker oder Zuckerderivate, wie z.B. Saccharose, Glucose, Fructose, Lactose, Zuckeralkohole wie z.B. Sorbit, Mannit, Furanderivate, wie z.B. 2- Furancarbonsäure, 3-Furancarbonsäure, und/oder Di- oder Polyalkohole, wie z.B. Ethylenglycol, Glycerin, Di- bzw. Triethylenglycol, zugesetzt. Bevorzugt werden als leitfähigkeitserhöhende Additive Tetrahydrofuran, N-Methylformamid, N-Methylpyrrolidon, Dimethylsulfoxid oder Sorbit eingesetzt. Besonders bevorzugt ist Dimethylsulfoxid. Die Additive werden den wässrigen Dispersionen zur Herstellung der ersten Schicht vorzugsweise in einer Menge von mindestens 0,1 Gew.-%, bevorzugt von mindestens 0,5 Gew.-%, besonders bevorzugt von mindestens 1 Gew-%, bezogen auf das Gesamtgewicht der Dispersion, zugesetzt.

Materialien für die zweite Schicht sind Polythiophene enthaltend wiederkehrende Einheiten der allgemeinen Formel (II-a) und/oder (II-b), 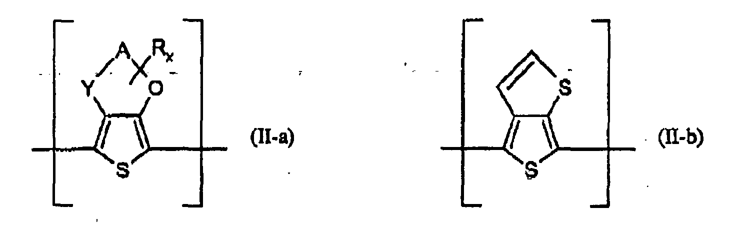 worin
- A: für einen gegebenenfalls substituierten C₁-C₅-Alkylenrest, bevorzugt für einen gegebenenfalls substituierten C₂-C₃-Alkylenrest steht,
- Y: für O oder S steht,
- R: für einen linearen oder verzweigten, gegebenenfalls substituierten C₁-C₁₈Alkylrest, einen gegebenenfalls substituierten C₅-C₁₂-Cycloalkylrest, einen gegebenenfalls substituierten C₆-C₁₄-Arylrest, einen gegebenenfalls substituierten C₇-C₁₈-Aralkylrest, einen gegebenenfalls substituierten C₁-C₄-Hydroxyalkylrest oder einen Hydroxylrest steht,
- x: für eine ganze Zahl von 0 bis 8, bevorzugt für 0 oder 1 steht und
für den Fall, dass mehrere Reste R an A gebunden sind, diese gleich oder unterschiedlich sein können,
weiterhin enthaltend wenigstens ein polymeres Anion.

Bevorzugt sind Polythiophene enthaltend wiederkehrenden Einheiten der allgemeinen Formel (II-a) solche enthaltend wiederkehrende Einheiten der allgemeinen Formel (II-a-1) und/oder (II-a-2), 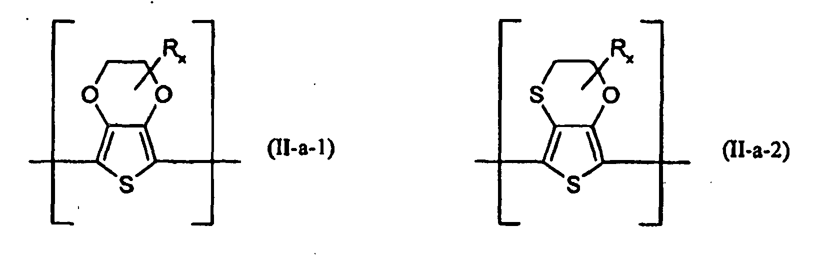 worin
- R und x: die oben genannte Bedeutung haben.

Besonders bevorzugt sind dies solche Polythiophene enthaltend wiederkehrende Einheiten der allgemeinen Formel (II-aa-1) und/oder (II-aa-2)

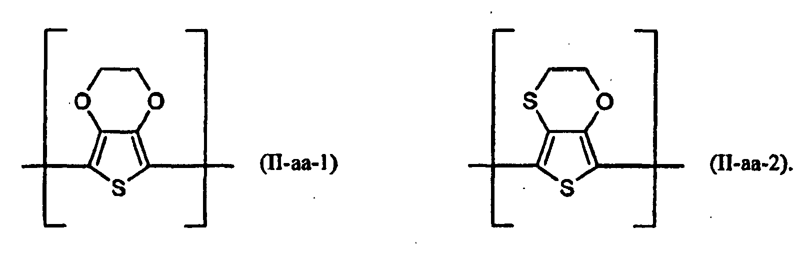

In besonders bevorzugten Ausführungsformen ist das Polythiophen mit wiederkehrenden Einheiten der allgemeinen Formel (II-a) und/oder (II-b) Poly(3,4-ethylendioxythiophen), Poly(3,4-ethylenoxythiathiophen) oder Poly(thieno[3,4-b]thiophen, d.h. ein Homopolythiophen aus wiederkehrenden Einheiten der Formel (II-aa-1), (II-aa-2) oder (II-b).

In weiteren besonders bevorzugten Ausführungsformen ist das Polythiophen mit wiederkehrenden Einheiten der allgemeinen Formel (II-a) und/oder (II-b) ein Copolymer aus wiederkehrenden Einheiten der Formel (II-aa-1) und (II-aa-2), (II-aa-1) und (II-b), (II-aa-2) und (II-b) oder (II-aa-1), (II-aa-2) und (II-b), wobei Copolymere aus wiederkehrenden Einheiten der Formel (II-aa-1) und (II-aa-2) sowie (II-aa-1) und (II-b) bevorzugt sind.

C₁-C₅-Alkylenreste A sind im Rahmen der Erfindung: Methylen, Ethylen, n-Propylen, n-Butylen oder n-Pentylen. C₁-C₁₈-Alkyl steht im Rahmen der Erfindung für lineare oder verzweigte C₁-C₁₈-Alkylreste wie beispielsweise Methyl, Ethyl, n- oder iso-Propyl, n-, iso-, sec- oder tert-Butyl, n-Pentyl, 1-Methylbutyl, 2-Methylbutyl, 3-Methylbutyl, 1-Ethylpropyl, 1,1-Dimethylpropyl, 1,2-Dimethylpropyl, 2,2-Dimethylpropyl, n-Hexyl, n-Heptyl, n-Octyl, 2-Ethylhexyl, n-Nonyl, n-Decyl, n-Undecyl, n-Dodecyl, n-Tridecyl, n-Tetradecyl, n-Hexadecyl oder n-Octadecyl, C₅-C₁₂-Cycloalkyl für C₅-C₁₂-Cycloalkylreste, wie Cyclopentyl, Cyclohexyl, Cycloheptyl, Cyclooctyl, Cyclononyl oder Cyclodecyl, C₅-C₁₄-Aryl für C₆-C₁₄-Arylreste wie Phenyl oder Naphthyl, und C₇-C₁₈-Aralkyl für C₇-C₁₈-Aralkylreste wie beispielsweise Benzyl, o-, m-, p-Tolyl, 2,3-, 2,4-, 2,5-, 2,6-, 3,4-, 3,5-Xylyl oder Mesityl. Die vorangehende Aufzählung dient der beispielhaften Erläuterung der Erfindung und ist nicht als abschließend zu betrachten.

Als gegebenenfalls weitere Substituenten der C₁-C₅-Alkylenreste A kommen zahlreiche organische Gruppen in Frage, beispielsweise Alkyl-, Cycloalkyl-, Aryl-, Halogen-, Ether-, Thioether-, Disulfid-, Sulfoxid-, Sulfon-, Sulfonat-, Amino-, Aldehyd-, Keto-, Carbonsäureester-, Carbonsäure-, Carbonat-, Carboxylat-, Cyano-, Alkylsilan- und Alkoxysilangruppen sowie Carboxylamidgruppen.

Bevorzugte polymere Anionen sind beispielsweise Anionen polymerer Carbonsäuren, wie Polyacrylsäuren, Polymethacrylsäure oder Polymaleinsäuren, oder polymerer Sulfonsäuren, wie Polystyrolsulfonsäuren und Polyvinylsulfonsäuren. Diese Polycarbon- und -sulfonsäuren können auch Copolymere von Vinylcarbon- und Vinylsulfonsäuren mit anderen polymerisierbaren Monomeren, wie Acrylsäureestern und Styrol, sein.

Besonders bevorzugt als polymeres Anion ist das Anion der Polystyrolsulfonsäure (PSS) als Gegenion.

Zusätzlich zu den vorangehend genannten eignen sich für die zweite Elektrodenschicht insbesondere in Kombination mit den Polythiophenen enthaltend wiederkehrende Einheiten der allgemeinen Formeln (II-a) und/oder (II-b) als polymere Anionen auch SO₃⁻M⁺- oder COO-M⁺-Gruppen enthaltende teilfluorierte oder perfluorierte Polymere. Bei einem solchen SO₃⁻M⁺- oder

COO⁻M⁺-Gruppen enthaltenden teilfluorierten oder perfluorierten Polymer kann es sich beispielsweise um Nafion^{®} handeln, welches kommerziell im Handel erhältlich ist. Auch eine Mischung aus Anionen der Polystyrolsulfonsäure (PSS) und Nafion^{®} kommen als polymere Anionen für die zweite Elektrodenschicht in Frage.

Das Molekulargewicht der die Polyanionen liefernden Polysäuren beträgt vorzugsweise 1 000 bis 2 000 000, besonders bevorzugt 2 000 bis 500 000. Die Polysäuren oder ihre Alkalisalze sind im Handel erhältlich, z.B. Polystyrolsulfonsäuren und Polyacrylsäuren, oder aber nach bekannten Verfahren herstellbar (siehe z.B. Houben Weyl, Methoden der organischen Chemie, Bd. E 20 Makromolekulare Stoffe, Teil 2, (1987), S. 1141 u.f.).

Die Polythiophene können neutral oder kationisch sein. In bevorzugten Ausfiihrungsformen sind sie kationisch, wobei sich "kationisch" nur auf die Ladungen bezieht, die auf der Polythiophenhauptkette sitzen. Je nach Substituent an den Resten R können die Polythiophene positive und negative Ladungen in der Struktureinheit tragen, wobei sich die positiven Ladungen auf der Polythiophenhauptkette und die negativen Ladungen gegebenenfalls an den durch Sulfonat- oder Carboxylatgruppen substituierten Resten R befinden. Dabei können die positiven Ladungen der Polythiophenhauptkette zum Teil oder vollständig durch die gegebenenfalls vorhandenen anionischen Gruppen an den Resten R abgesättigt werden. Insgesamt betrachtet können die Polythiophene in diesen Fällen kationisch, neutral oder sogar anionisch sein. Dennoch werden sie im Rahmen der Erfindung alle als kationische Polythiophene betrachtet, da die positiven Ladungen auf der Polythiophenhauptkette maßgeblich sind. Die positiven Ladungen sind in den Formeln nicht dargestellt, da ihre genaue Zahl und Position nicht einwandfrei feststellbar sind. Die Anzahl der positiven Ladungen beträgt jedoch mindestens 1 und höchstens n, wobei n die Gesamtanzahl aller wiederkehrenden Einheiten (gleicher oder unterschiedlicher) innerhalb des Polythiophens ist.

Zur Kompensation der positiven Ladung, soweit dies nicht bereits durch die gegebenenfalls Sulfonat- oder Carboxylat-substituierten und somit negativ geladenen Reste R erfolgt, benötigen die kationischen Polythiophene Anionen als Gegenionen.

Als Gegenionen kommen monomere oder polymere Anionen, letztere im Folgenden auch als Polyanionen bezeichnet, in Frage.

Als polymere Anionen kommen die vorangehend bereits aufgeführten in Frage. Als monomere Anionen dienen beispielsweise solche von C₁-C₂₀-Alkansulfonsäuren, wie der Methan-, Ethan-, Propan-, Butan- oder höheren Sulfonsäuren, wie der Dodecansulfonsäure, von aliphatischen Perfluorsulfonsäuren, wie der Trifluormethansulfonsäure, der Perfluorbutansulfonsäure oder der Perfluoroctansulfonsäure, von aliphatischen C₁-C₂₀-Carbonsäuren wie der 2-Ethylhexylcarbonsäure, von aliphatischen Perfluorcarbonsäuren, wie der Trifluoressigsäure oder der Perfluoroctansäure, und von aromatischen, gegebenenfalls durch C₁-C₂₀-Alkylgruppen substituierten Sulfonsäuren wie der Benzolsulfonsäure, o-Toluolsulfonsäure, p-Toluolsulfonsäure oder der Dodecylbenzolsulfonsäure und von Cycloalkansulfonsäuren wie Camphersulfonsäure oder Tetrafluoroborate, Hexafluorophosphate, Perchlorate, Hexafluoroantimonate, Hexafluoroarsenate oder Hexachloroantimonate.

Besonders bevorzugt sind die Anionen der p-Toluolsulfonsäure, Methansulfonsäure oder Camphersulfonsäure.

Kationische Polythiophene, die zur Ladungskompensation Anionen als Gegenionen enthalten, werden in der Fachwelt auch oft als Polythiophen/(Poly-)Anion-Komplexe bezeichnet.

In den Schichten enthaltend wenigstens ein polymeres Anion und wenigstens ein Polythiophen mit wiederkehrenden Einheiten der allgemeinen Formel (I) oder (II-a) und/oder (II-b) kann das polymere Anion als Gegenion fungieren. Es können jedoch auch zusätzliche Gegenionen in der Schicht enthalten sein. Bevorzugt dient jedoch in dieser Schicht das polymere Anion als Gegenion.

Polymere(s) Anion(en) und Polythiophen(e) können in der ersten Schicht in einem Gewichtsverhältnis von 0.5:1 bis 20:1, bevorzugt von 1:1 bis 5:1 enthalten sein. Polymere(s) Anion(en) und Polythiophen(e) können in der zweiten Schicht in einem Gewichtsverhältnis von 0,5:1 bis 50:1, bevorzugt von 1:1 bis 30:1, besonders bevorzugt 2:1 bis 20:1 enthalten sein. Das Gewicht der Polythiophene entspricht hierbei der Einwaage der eingesetzten Monomere unter Annahme, dass bei der Polymerisation vollständiger Umsatz erfolgt.

In bevorzugten Ausführungsformen wird die erste Schicht hergestellt aus einer wässrigen Dispersion enthaltend ein Polyanion und einem Polythiophen mit wiederkehrenden Einheiten der allgemeinen Formel (I), in der R, A und x die oben genannte Bedeutung haben, auf die eine zweite Schicht aus einer Dispersion enthaltend ein polymeres Anion und ein Polythiophen mit wiederkehrenden Einheiten der allgemeinen Formel (II-a) und/oder (II-b) aufgebracht wird.

In einer ganz besonders bevorzugten Ausführungsform wird die erste Schicht hergestellt aus einer wässrigen Dispersion enthaltend Polystyrolsulfonsäure und Poly(3,4-ethylendioxythiophen) auf die eine zweite Schicht aus einer wässrigen Dispersion enthaltend Polystyrolsulfonsäure und Poly(3,4-ethylendioxythiophen), in Fachkreisen auch als PEDT/PSS oder PEDT:PSS bezeichnet, aufgebracht wird.

Die wässrigen Dispersionen - sowohl zur Herstellung der ersten als auch zur Herstellung der zweiten Elektrodenschicht - können außerdem ein oder mehrere Lösungsmittel enthalten. Als Lösungsmittel kommen beispielsweise aliphatische Alkohole wie Methanol, Ethanol, i-Propanol und Butanol, aliphatische Ketone wie Aceton und Methylethylketon, aliphatische Carbonsäureester wie Essigsäureethylester und Essigsäurebutylester, aromatische Kohlenwasserstoffe wie Toluol und Xylol; aliphatische Kohlenwasserstoffe wie Hexan, Heptan und Cyclohexan, Chlorkohlenwasserstoffe wie Dichlormethan und Dichlorethan, aliphatische Nitrile wie Acetonitril, aliphatische Sulfoxide und Sulfone wie Dimethylsulfoxid und Sulfolan, aliphatische Carbonsäureamide wie Methylacetamid, Dimethylacetamid und Dimethylformamid, aliphatische und araliphatische Ether wie Diethylether und Anisol in Frage. Bevorzugte Lösungsmittel sind Wasser oder sowie Mischungen von Wasser mit Methanol, Ethanol, i-Propanol und Butanol, besonders bevorzugtes Lösungsmittel ist Wasser.

Für den Fall, dass die wässrigen Dispersionen ein oder mehrere Lösungsmittel enthalten liegt der Feststoffanteil dieser Dispersionen bevorzugt bei 0,01% bis 20%, besonders bevorzugt bei 0,1% bis 10% bezogen auf das Gesamtgewicht der Dispersion.

Die wässrigen Dispersionen zur Herstellung der ersten Elektrodenschicht weisen bevorzugt eine Viskosität von 5 bis 300 mPas, bevorzugt von 10 bis 100 mPas auf. Die wässrigen Dispersionen zur Herstellung der zweiten Elektrodenschicht weisen bevorzugt eine Viskosität von 2 bis 300 mPas, bevorzugt von 5 bis 100 mPas auf.

Die Viskosität der hier untersuchten Lösungen wird mit einem Rheometer Haake RV 1 mit Thermostat gemessen. In den sauberen und trockenen Messbecher werden 13,5 g ± 0,3 g der zu messenden Lösungen in den Messspalt eingewogen und bei einer Scherrate von 100 s⁻¹ bei 20,0°C gemessen.

Den wässrigen Dispersionen zur Herstellung der zweiten Elektrodenschicht können außerdem weitere Komponenten wie ein oder mehrere in organischen Lösungsmitteln lösliche organische Binder wie Polyvinylacetat, Polycarbonat, Polyvinylbutyral, Polyacrylsäureester, Polymethacrylsäureester, Polystyrol, Polyacrylnitril, Polyvinylchlorid, Polybutadien, Polyisopren, Polyether, Polyester, Silicone, Styrol/Acrylsäureester-, Vinylacetat/Acrylsäureester- und Ethylen/Vinylacetat-Copolymerisate, wasserlösliche Binder wie Polyvinylalkohole und/oder Vernetzer wie Polyurethane bzw. Polyurethandispersionen, Polyacrylate, Polyolefindispersionen, Epoxysilane, wie 3-Glycidoxypropyltrialkoxysilan zugesetzt werden.

Die wässrigen Dispersionen werden nach bekannten Verfahren, z.B. durch Spincoating, Tränkung, Gießen, Auftropfen, Spritzen, Aufsprühen, Aufrakeln, Bestreichen oder Bedrucken, beispielsweise Ink-jet-, Gravur-, Sieb-, Flexo- oder Tampondrucken auf das geeignete Substrat bzw. die erste Schicht aufgebracht.

An die jeweilige Aufbringung der ersten und zweiten Schicht enthaltend wenigstens ein polymeres Anion und wenigstens ein Polythiophen mit wiederkehrenden Einheiten der allgemeinen Formel (I) bzw. (II-a) und/oder (II-b) kann sich anschließend an die Verfestigung - beispielsweise mittels Trocknung - eine Reinigung der Schicht - beispielsweise durch Waschen - anschließen.

Die Herstellung der wässrigen Dispersionen erfolgt aus Thiophenen der allgemeinen Formel (II) beispielsweise analog zu den in EP-A 440 957 genannten Bedingungen. Zur Erzielung dieser Partikelgrößen wird die wässrige Dispersion in dem Fachmann ebenfalls bekannter Weise zur Herstellung der ersten Schicht vorzugsweise ein oder mehrfach gegebenenfalls bei erhöhtem Druck homogenisiert. Der Feststoffgehalt kann von vorneherein in gewünschter Weise durch die Wahl der Mengen des gegebenenfalls vorhandenen Lösungsmittels eingestellt oder in bekannter Weise nachträglich durch Verdünnen erniedrigt oder durch Aufkonzentrieren erhöht werden.

Die erste Schicht wird vor Aufbringung der zweiten Schicht verfestigt, insbesondere bei Lösungsmittelhaltigen wässrigen Dispersionen durch Entfernen des Lösungsmittels oder durch oxidative Vernetzung, bevorzugt durch Aussetzen der Dispersionsschicht mit (Luft)-Sauerstoff.

Das Entfernen von gegebenenfalls vorhandenem Lösungsmittel nach dem Aufbringen der Lösungen kann durch einfaches Verdampfen bei Raumtemperatur erfolgen. Zur Erzielung höherer Verarbeitungsgeschwindigkeiten ist es jedoch vorteilhafter, die Lösungsmittel bei erhöhten Temperaturen, z.B. bei Temperaturen von 20 bis zu 300°C, bevorzugt von 40 bis zu 200°C. Je nach Additiv in der wässrigen Dispersion zur Herstellung der ersten Elektrodeschicht kann deren Trocknungstemperatur besonders bevorzugt bei 100 bis zu 150°C gewählt werden. Eine thermische Nachbehandlung kann unmittelbar mit dem Entfernen des Lösungsmittels verbunden oder aber auch in zeitlichem Abstand von der Fertigstellung der Beschichtung vorgenommen werden. Die Dauer der Wärmebehandlung kann in Abhängigkeit von der Art des für die Beschichtung verwendeten Polymers 5 Sekunden bis mehrere Stunden betragen. Für die thermische Behandlung können auch Temperaturprofile mit unterschiedlichen Temperaturen und Verweilzeiten eingesetzt werden.

Die Wärmebehandlung kann z.B. in der Weise ausgeführt werden, dass man die beschichteten Substrate mit einer solchen Geschwindigkeit durch eine auf der gewünschten Temperatur befindliche Wärmekammer bewegt, dass die gewünschte Verweilzeit bei der gewählten Temperatur erreicht wird, oder mit einer auf der gewünschten Temperatur befindlichen Heizplatte für die gewünschte Verweilzeit in Kontakt bringt. Des Weiteren kann die Wärmebehandlung beispielsweise in einem Wärmeofen oder mehreren Wärmeöfen mit jeweils unterschiedlichen Temperaturen erfolgen.

Bei dem Substrat kann es sich beispielsweise um Glas, Dünnstglas (flexibles Glas) oder Kunststoffe handeln. Das Substrat kann vor Aufbringen der Schicht enthaltend wenigstens ein leitfähiges Polymer mit einem Haftvermittler behandelt werden. Eine solche Behandlung kann beispielsweise durch Spincoating, Tränkung, Gießen, Auftropfen, Spritzen, Aufsprühen, Aufrakeln, Bestreichen oder Bedrucken, beispielsweise Ink-jet-, Gravur-, Sieb-, Flexo- oder Tampondrucken erfolgen.

Besonders geeignete Kunststoffe für das Substrat sind: Polycarbonate, Polyester wie z.B. PET und PEN (Polyethylenterephthalat bzw. Polyethylennaphthalindicarboxylat), Copolycarbonate, Polysulfon, Polyethersulfon (PES), Polyimid, Polyethylen, Polypropylen oder cyclische Polyolefine bzw. cyclische Olefincopolymere (COC), hydrierte Styrolpolymere oder hydrierte Styrolcopolymere.

Geeignete Polymerunterlagen (Substrate) können beispielsweise Folien wie Polyesterfolien, PES-Folien der Firma Sumitomo oder Polycarbonatfolien der Firma Bayer AG (Makrofol^{®}) sein.

Bevorzugte niedermolekulare löcherinjizierende Materialien sind gegebenenfalls substituierte Phtalocyanine, wie Cu-Phtalocyanin (S. A. Van Slyke et al., Appl. Phys. Lett. 69 (1996) 2160) oder gegebenenfalls substituierte Phenylamine wie 4,4'-Bis(3-methylphenylphenyl-amino)biphenyl (TPD) oder 4,4',4"-Tris(3-methylphenylphenylamino)triphenylamin (m-MTDATA) ((Y. Shirota et al., Appl. Phys. Lett. 65 (1994) 807, die gegebenenfalls weiterhin mit 2,3,5,6-Tetrafluoro-7,7,8,8-tetracyanoquinodimethan (F4-TCNQ) oder anderen Donatoren oder Akzeptoren dotiert sein können (M.Pfeiffer et al., Adv. Mat. 14 (2002) 1633).

Die zweite Schicht der erfindungsgemäßen Elektrode wird aus wässriger Dispersion hergestellt.

Das erfindungsgemäße Verfahren kommt somit bevorzugt ohne aufwendige und teure Aufdampf- oder Aufsputterverfahren aus. Dadurch wird unter anderem auch eine großflächige Anwendung ermöglicht. Außerdem lassen sich die Polythiophen/Polyanion-Schichten bei niedrigen Temperaturen, vorzugsweise Raumtemperatur aufbringen. Das erfindungsgemäße Verfahren ist somit auch für die Aufbringung auf polymere, flexible Substrate geeignet, die in der Regel nur Niedertemperaturprozesse vertragen und den Temperaturen bei der ITO-Abscheidung nicht standhalten.

Weiterhin Gegenstand der vorliegenden Erfindung sind Elektroden, die mit dem erfindungsgemäßen Verfahren herstellbar sind, bevorzugt hergestellt wurden.

Bevorzugt handelt es sich bei der erfindungsgemäßen Elektrode um eine transparente Elektrode. Transparent im Sinne der Erfindung bedeutet transparent für sichtbares Licht.

Der Normfarbwert Y der ersten Schicht der erfindungsgemäßen Elektrode weist bevorzugt mindestens Y(D65/10°) = 50, besonders bevorzugt mindestens Y(D65/10°) = 70 auf.

Die Lichttransmission (engl. "luminous transmittance") wird entsprechend der ASTM D 1003 wellenlängenabhängig gemessen und daraus wird der Normfarbwert Y - oft auch als Helligkeit bezeichnet - entsprechend der ASTM E308 berechnet. Für eine völlig transparente Probe beträgt Y = 100, für eine lichtundurchlässige Probe beträgt Y = 0. Unter Y(D65/10°) versteht man lichttechnisch den Normfarbwert, der mit Hilfe der Normlichtart D65 unter 10° Beobachtung (vgl. ASTM E308) berechnet wird. Die angegebenen Normfarbwerte beziehen sich auf die reine Schicht, d.h. als Referenz wird ein unbeschichtetes Substrat mitgemessen.

Die erste Schicht der erfindungsgemäßen Elektrode weist bevorzugt eine elektrische Leitfähigkeit von mindestens 300 Scm⁻¹, besonders bevorzugt von mindestens 400 Scm⁻¹ auf.

Unter der elektrischen Leitfähigkeit ist der Kehrwert des spezifischen Widerstands gemeint. Dieser wird aus dem Produkt von Oberflächenwiderstand und Schichtdicke der leitfähigen Polymerschicht errechnet. Der Oberflächenwiderstand wird für leitfähige Polymere entsprechend der DIN EN ISO 3915, die Dicke der Polymerschicht wird mit Hilfe eines Stylus-Profilometers gemessen.

Weiterhin bevorzugt weist die erste Schicht der erfindungsgemäßen Elektrode eine Oberflächenrauhigkeit Ra von weniger als 2,5 nm, bevorzugt von weniger als 1,5 nm auf.

Die Oberflächenrauhigkeit Ra wird mit Hilfe eines Raster-Kraft-Mikroskops (Digital Instruments) gemessen, indem eine ca. 150 nm dicke Polymerschicht auf Glassubstraten auf einer Fläche von 1 µm x 1 µm abgetastet wird.

Die Oberflächenrauhigkeit der ersten Schicht der erfindungsgemäßen Elektrode ist vorteilhafterweise deutlich kleiner als beispielsweise die der aus EP-A 686 662 bekannten Elektroden, so dass die Kurzschlusswahrscheinlichkeit für OLEDs und OSCs mit den erfmdungsgemäßen Elektroden reduziert wird.

Weiterhin bevorzugt weist die erste Schicht der erfindungsgemäßen Elektrode eine Trockenfilmdicke von 10 bis 500 nm, besonders bevorzugt von 20 bis 200 nm, ganz besonders bevorzugt von 50 bis 200 nm auf. Die zweite Schicht der erfindungsgemäßen Elektrode weist bevorzugt eine Trockenfilmdicke von 5 bis 300 nm, besonders bevorzugt von 10 bis 200 nm, besonders bevorzugt von 50 bis 150 nm auf.

In bevorzugten Ausführungsformen enthält die Elektrode eine erste Schicht aus einem Polyanion und einem Polythiophen mit wiederkehrenden Einheiten der allgemeinen Formel (I), in der R, A und x die oben genannte Bedeutung haben, auf die eine zweite Schicht aus einem polymeren Anion und einem Polythiophen mit wiederkehrenden Einheiten der allgemeinen Formel (II-a) und/oder (II-b) aufgebracht ist.

In einer ganz besonders bevorzugten Ausfiihrungsform enthält die Elektrode eine erste Schicht aus Polystyrolsulfonsäure und Poly(3,4-ethylendioxythiophen) auf die eine zweite Schicht aus Polystyrolsulfonsäure und Poly(3,4-ethylendioxythiophen), in Fachkreisen auch als PEDT/PSS oder PEDT:PSS bezeichnet, aufgebracht ist.

Die erfindungsgemäßen Elektroden eignen sich hervorragend als Elektroden in elektrischen und bevorzugt in elektrooptischen Aufbauten, insbesondere in organischen Leuchtdioden (OLED), organischen Solarzellen (OSC), elektrophoretischen oder flüssigkristallinen Anzeigen (LCD) und optischen Sensoren.

Elektrooptische Aufbauten enthalten in der Regel zwei Elektroden, wovon mindestens eine lichtdurchlässig ist, und dazwischen ein elektrooptisch aktives Schichtsystem. Im Fall von OLEDs handelt es sich bei dem elektrooptischen Aufbau um eine elektrolumineszierende Schichtanordnung, die im Folgenden auch kurz als elektrolumineszierende Anordnung oder EL-Anordnung bezeichnet wird.

Der einfachste Fall einer solchen EL-Anordnung besteht aus zwei Elektroden, von denen mindestens eine transparent ist, und einer elektrooptisch aktiven Schicht zwischen diesen beiden Elektroden. Zusätzlich können jedoch weitere funktionelle Schichten in einem solchen elektrolumineszierenden Schichtaufbau enthalten sein, wie z.B. weitere ladungsinjizierende, ladungstransportierende oder ladungsblockierende Zwischenschichten. Solche Schichtaufbauten sind dem Fachmann bekannt und beispielsweise in (J.R.Sheats et al.,Science 273, (1996), 884) beschrieben. Eine Schicht kann auch mehrere Aufgaben übernehmen. Im vorangehend beschriebenen einfachsten Fall einer EL-Anordnung kann die elektrooptisch aktive, d.h. in der Regel lichtemittierende, Schicht die Funktionen der anderen Schichten übernehmen. Eine der beiden Elektroden oder beide Elektroden können auf ein geeignetes Substrat, d.h. einen geeigneten Träger, aufgebracht sein. Der Schichtaufbau wird dann entsprechend kontaktiert und gegebenenfalls umhüllt und/oder verkapselt.

Der Aufbau von Mehrschichtsystemen kann durch Aufdampfverfahren (engl.: "Physical Vapour deposition", PVD), bei denen die Schichten sukzessive aus der Gasphase aufgebracht werden, oder durch Gießverfahren erfolgen. Die Aufdampfverfahren werden in Verbindung mit der Lochmaskentechnik zur Fabrikation von strukturierten LEDs benutzt, die als Emitter organische Moleküle benutzen. Gießverfahren sind aufgrund der höheren Prozessgeschwindigkeiten und der geringeren Menge an produziertem Ausschussmaterial und der damit verbundenen Kostenersparnis generell bevorzugt.

Die erfindungsgemäßen Elektroden lassen sich - wie bereits vorangehend beschrieben - aus einer Dispersion herstellen Weiterer Gegenstand der vorliegenden Erfindung ist daher eine elektrolumineszierende Anordnung bestehend wenigstens aus zwei Elektroden, von denen mindestens eine Elektrode transparent ist, und einer elektro-optisch aktiven Schicht zwischen den Elektroden, dadurch gekennzeichnet, das sie eine erfindungsgemäße Elektrode als transparente Elektrode enthält.

Bevorzugte elektrolumineszierende Anordnungen sind solche, die eine auf ein geeignetes Substrat aufgebrachte erfindungsgemäße Elektrode, d.h. erste und zweite Schicht, eine Emitter-Schicht und eine Metallkathode enthalten. Beispielsweise kann in einer solchen EL-Anordnung die Schicht enthaltend wenigstens ein organisches, löcherinjizierendes Material, vorzugsweise wenigstens ein polymeres Anion und wenigstens ein Polythiophen der allgemeinen Formel (II-a) oder (II-b) als löcherinjizierende Zwischenschicht fungieren. Gegebenenfalls können weitere der vorangehend aufgeführten funktionellen Schichten enthalten sein.

Die elektrisch leitfähige Schicht wird insbesondere mit mehreren elektrisch hochleitfähigen metallischen Zuleitungen als Anode kontaktiert.

Eine bevorzugte Ausführungsform der vorliegenden Erfindung ist eine EL-Anordnung aus Schichten in folgender Reihenfolge:
Substrat // (Polyethylendioxythiophen/Polystyrolsulfonsäure)-Schicht (erste Schicht) // (Polyethylendioxythiophen/Polystyrolsulfonsäure)-Schicht (zweite Schicht) // Emitter-Schicht // Metallkathode.
Gegebenenfalls können weitere funktionelle Schichten enthalten sein.
Entsprechende Aufbauten mit erfindungsgemäßer Elektrode sind auch bei invertierten OLED- oder OSC-Aufbauten von Vorteil, d.h. wenn der Schicht-Aufbau in umgekehrter Reihenfolge erfolgt. Eine entsprechende bevorzugte Ausführungsform eines invertierten OLED's ist die folgende:
   Substrat // Metallkathode // Emitter-Schicht // (Polyethylendioxythiophen/Polystyrolsulfonsäure)-Schicht (zweite Schicht) // (Polyethylendioxythiophen/Polystyrolsulfonsäure)-Schicht (erste Schicht).

Invertierte OLEDs sind insbesondere in Kombination mit Aktiv-Matrix Substraten von großem Interesse. Bei Aktiv-Matrix Substraten handelt es sich in der Regel um nicht-transparente Si-Schichten bei denen unter jedem Leuchtpixel eine Transistorschaltung prozessiert wurde.

Beim Einsatz von erfindungsgemäßen Elektroden in invertierten OLED's wird in der Regel zunächst die zweite Schicht wie bereits vorangehend beschrieben auf die Emitterschicht und anschließend nach Verfestigung dieser zweiten Schicht die erste Schicht wie bereits vorangehend beschrieben auf die Emitterschicht aufgebracht.

Geeignete Emittermaterialien und Materialien für Metallkathoden sind die für elektrooptische Aufbauten gängigen und dem Fachmann bekannt. Als Metallkathode kommen bevorzugt solche aus Metallen mit geringer Austrittsarbeit wie Mg, Ca, Ba, Cs oder Metallsalzen wie LiF in Betracht. Als Emittermaterialien kommen bevorzugt konjugierte Polymere wie Polyphenylenvinylene oder Polyfluorene oder Emitter aus der Klasse der niedermolekularen Emitter, in Fachkreisen auch als "small molecules" bezeichnet, wie Tris(8-hydroxyquinolinato)aluminium (Alq₃) in Betracht.

Die erfindungsgemäße Elektrode hat in elektrooptischen Aufbauten gegenüber bekannten Elektroden eine Reihe von Vorteilen:
a) Auf TCO-Schichten, wie beispielsweise ITO, oder dünne Metallschichten kann z.B. in OLEDs und OSCs verzichtet werden
b) Im Fall von flexiblen Substraten kommt es bei Biegung des Substrats nicht zu Rissen in den spröden TCO-Schichten und einem Ausfall des elektrooptischen Aufbaus, da diese polymeren Schichten sehr duktil und flexibel sind.
c) Organische Schichten lassen sich einfacher strukturieren als anorganische wie z.B. ITO. Organische Schichten können mit Lösungsmitteln, durch optische Bestrahlung (UV) oder thermische Bestrahlung (Laser-Ablation) wieder entfernt werden.

Die erfindungsgemäße Doppelschicht-Elektrode aus erster und zweiter Schicht zeigt weiterhin deutliche Vorteile gegenüber bekannten Polymer-Elektroden. Insbesondere die feine Teilchenstruktur und geringe Oberflächenrauhigkeit wird die Kurzschlusswahrscheinlichkeit für OLEDs und OSCs mit den erfindungsgemäßen Elektroden erheblich reduziert. Die deutlich erhöhte Leitfähigkeit der ersten Elektrodenschicht ist zudem überraschend, da auch aus der Literatur bekannt ist, dass eine Verringerung der Teilchengröße den Oberflächenwiderstand resultierender Schichten erhöht (A.Elschner et al., Asia Display IDW 2001, OEL 3-3, p. 1429;). Selbst eine Zugabe leitfähigkeitserhöhender Additive sollte erwartungsgemäß diesen negativen Einfluss der Teilchenverfeinerung auf die Leitfähigkeit nicht kompensieren geschweige denn die Leitfähigkeit noch erhöhen können. Durch den Einsatz der erfindungsgemäßen Elektroden lassen sich die Elektroluminszenzausbeute in OLEDs deutlich erhöhen. Insbesondere unter Verwendung der erfindungsgemäßen Elektroden gemäß den besonders bevorzugten Ausführungsformen , worin sowohl erste als auch zweite Elektrodenschicht PEDT:PSS enthält, ist eine solche Steigerung der Elektroluminszenzausbeute gegenüber Einschichtelektroden bei gleichem Devicestrom von 1 bis 3 Größenordnungen zu erzielen.

Der gefundene Effekt ist unerwartet, da in beiden Schichten die einzige elektrisch aktive Komponente das elektrisch leitfähige Polythiophen ist, wohingegen die polymeren Anionen elektrisch inert sind und vor allem dazu dienen, das elektrisch leitfähige Polymer bzw. Polythiophen bei der Polymerisation in Lösung zu halten und die leitfähigkeitserhöhenden Additive sich bei Trocknungstemperaturen von mehr als 120°C im Wesentlichen verflüchtigen.

Um den Spannungsabfall zwischen Anodenkontaktstelle und OLED-Anode besonders klein zu halten, können hochleitfähige Zuführungen, beispielsweise aus Metallen, sogenannte "bus-bars" verwendet werden.

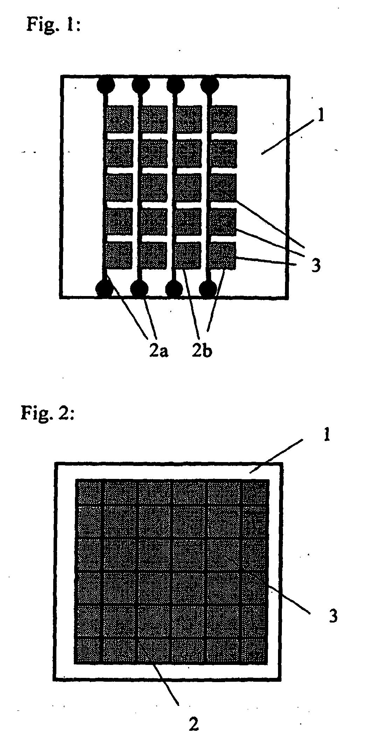

Im Fall von Passiv-Matrix-OLED-Displays kann aufgrund der Erfindung auf ITO-Adresslinien verzichtet werden. An deren Stelle übernehmen metallische Zuleitungen (bus-bars) in Kombination mit erfindungsgemäßer Elektrode die anodenseitige Adressierung (vgl. Fig.1). Auf einen transparenten Träger 1, z.B. eine Glasplatte, werden elektrische Zuleitungen 2a und Pixelrahmen 2b mit hoher Leitfähigkeit aufgebracht. Dies könnte z.B. durch Bedampfen von Metallen oder kostengünstig durch Bedrucken mit Metallpasten aufgebracht werden. In die Rahmen wird dann die polymere Elektrodenschicht 3 abgeschieden. Dabei wird zunächst gegebenenfalls ein Haftvermittler, dann die erste Elektrodenschicht und anschließend die zweite Elektrodenschicht aufgebracht. Die Aufbringung dieser Schichten erfolgt bevorzugt durch Spin-coating, Drucken und ink-jetting. Der weitere Aufbau entspricht dem einer Standard Passiv-Matrix-OLED und ist dem Fachmann bekannt.

Im Fall homogen leuchtender OLEDs (OLED-Lampen) kann aufgrund der Erfindung auf ITO-Elektroden verzichtet werden. An deren Stelle übernehmen metallische Zuleitungen (bus-bars) in Kombination mit erfindungsgemäßer Elektrode die Funktion der ganzflächigen Anode (vgl. Fig.2). Auf einen transparenten Träger 1, z.B. eine Glasplatte, werden elektrische Zuleitungen 2 mit hoher Leitfähigkeit beispielsweise wie im vorangehenden Abschnitt beschrieben aufgebracht. Darauf wird dann in der wie im vorangehenden Abschnitt beschriebenen Reihenfolge die polymere Elektrodenschicht 3 abgeschieden. Der weitere Aufbau entspricht dem einer Standard OLED-Lampe.

Die folgenden Beispiele dienen der beispielhaften Erläuterung der Erfindung und sind nicht als Beschränkung aufzufassen.

### Beispiele

Im Folgenden aufgeführte Partikelgrößenverteilungen wurden mit einer analytischen Ultrazentrifuge, wie in H.G. Müller; Progr. Colloid Polym Sci 127 (2004)9-13 beschrieben, bestimmt.

Die Lichttransmission (engl. "luminous transmittance") wird entsprechend der ASTM D 1003 wellenlängenabhängig gemessen und daraus wird die der Normfarbwert Y entsprechend der ASTM E308 berechnet. Für eine völlig transparente Probe beträgt Y = 100, für eine lichtundurchlässige Probe beträgt Y = 0. Unter Y(D65/10°) versteht man lichttechnisch den Normfarbwert, der mit Hilfe der Normlichtart D65 unter 10° Beobachtung (vgl. ASTM E308) berechnet wird. Gemessen wird die Transmission mit einem UV/VIS-Spektrometer (PerkinElmer 900 mit photointegrierender Kugel) mit einem unbeschichteten Glassubstrat im Referenzstrahlengang.

Die Viskosität der hier untersuchten Lösungen wird mit einem Rheometer Haake RV 1 mit Thermostat gemessen. In den sauberen und trockenen Messbecher werden 13,5 g ± 0,3 g der zu messenden Lösungen in den Messspalt eingewogen und bei einer Scherrate von 100 s⁻¹ bei 20,0°C gemessen.

Unter der Leitfähigkeit ist der Kehrwert des spezifischen Widerstands zu verstehen. Dieser wird aus dem Produkt von Oberflächenwiderstand und Schichtdicke der leitfähigen Polymerschicht errechnet. Der Oberflächenwiderstand wird für leitfähige Polymere entsprechend der DIN EN ISO 3915, die Dicke der Polymerschicht wird mit Hilfe eines Stylus-Profilometers gemessen.

Die Oberflächenrauhigkeit Ra wird mit Hilfe eines Raster-Kraft-Mikroskops (Digital Instruments) gemessen, indem eine ca. 150 nm dicke Polymerschicht auf Glassubstraten auf einer Fläche von 1 µm x 1 µm abgetastet wird.

### Beispiel 1

### Herstellung einer PEDT:PSS Dispersion für die Herstellung der ersten Elektrodenschicht:

a) (erfindungsgemäß) In einer kommerziell erhältlichen wässrigen Polyethylendioxythiophen/Polystyrolsulfonsäure-Dispersion (PEDT:PSS-Dispersion) mit einem Polyethylendioxythiophen/Polystyrolsulfonsäure-Gewichtsverhältnis von 1:2,5, einem Feststoffgehalt von ca. 1 Gew.-% und einer Viskosität von ca. 300 mPas bei einer Scherrate von 100 s⁻¹ und 20°C (Baytron^{®} PHC V4 der Firma H.C. Starck GmbH) wurde durch Homogenisierung eine Partikelgrößenverteilung mit einem d50-Wert von 25 nm eingestellt, d.h. 50 Gew.-% der Teilchen kleiner 25 nm. Anschließend wurde die Dispersion von ca. 1 Gew.-% auf einen Feststoffgehalt von 1,7 Gew.-% auflconzentriert, filtriert (Pall, Porengröße: 0,2µm) und anschließend mit 5 Gew.-% Dimethylsulfoxid (DMSO) gemischt. Die Viskosität dieser Lösung betrug ca. 45 mPas bei einer Scherrate von 100 s⁻¹ und 20°C.
b) (Vergleichsbeispiel) Eine kommerziell erhältliche wässrige PEDT:PSS-Dispersion mit einem Polyethylendioxythiophen/Polystyrolsulfonsäure-Gewichtsverhältnis von 1:2,5, einem Feststoffgehalt von ca. 1 Gew.-% und einer Viskosität von ca. 300 mPas bei einer Scherrate von 100 s⁻¹ und 20°C (Baytron^{®} PHC V4 der Firma H.C. Starck GmbH) mit einer Partikelgrößenverteilung mit einem d50-Wert von 243 nm wurde filtriert. Diese Dispersion ließ sich aufgrund ihrer Grobteiligkeit nur über einen 10µm-Filter filtrieren.
c) (Vergleichsbeispiel) Es wird eine PEDT:PSS-Dispersion wie unter 1b) beschrieben hergestellt und anschließend mit 5 Gew.-% Dimethylsulfoxid (DMSO) gemischt. Auch diese Dispersion ließ sich aufgrund ihrer Grobteiligkeit nur über einen 10µm-Filter filtrieren.

### Beispiel 2

### Herstellung und Charakterisierung einer ersten Elektrodenschicht:

a) (erfindungsgemäß) Glassubstrate wurden auf eine Größe von 50 x 50 mm² geschnitten, gereinigt und für 15 min mit UV/Ozon aktiviert. Anschließend wurde die Dispersion aus Beispiel 1a) mit einer Lackschleuder bei vorgegebener Spingeschwindigkeit und bei einer Beschleunigung von 500 U/min/sec für 30 sec auf dem Glassubstrat verteilt. Parallele Silber-Kontakte wurden über eine Schattenmaske aufgedampft und der Oberflächenwiderstand bestimmt. Die Schichtdicke wurde mit einem Stylusprofilometer (Tencor 500) bestimmt, die Oberflächenrauhigkeit mit einem Rasterkraftmikroskop (Digital Instruments)
b) (Vergleichsbeispiel) Wie unter 2a) beschrieben wurden Glassubstrate vorbereitet, mit einer Dispersion aus Beispiel 1b) beschichtet und deren Normfarbwert, Oberflächenwiderstand, Schichtdicke und Oberflächenrauhigkeit bestimmt.
c) (Vergleichsbeispiel) Wie unter 2a) beschrieben wurden Glassubstrate vorbereitet, mit einer Dispersion aus Beispiel 1c) beschichtet und deren Normfarbwert, Oberflächenwiderstand, Schichtdicke und Oberflächenrauhigkeit bestimmt.

**Tab. 1: Schichtdicke, Leitfähigkeit, Normfarbwert und Oberflächenrauhigkeit der ersten Elektrodenschichten aus den Beispielen 2a), b) und c).**

| **Beispiel** | **Spingeschwindigkeit [U/min]** | **Schichtdicke [nm]** | **Leitfähigkeit [S/cm]** | **Normfarbwert Y(D65/10°)** | **Oberflächenrauhigkeit Ra [nm]** |
|---|---|---|---|---|---|
| 2a) | 950 | 129 | 621 | 89.1 | 1.39 |
| 2b) | 1250 | 146 | 56 | 86.9 | 1.93 |
| 2c) | 1200 | 158 | 601 | 85.3 | 3.53 |

Der Vergleich der ersten Elektrodenschichten aus Beispiel 2a) bis 2c) zeigt, dass bei vergleichbarer Schichtdicke und Normfarbwert, die Leitfähigkeit der ersten Elektrodenschicht aus Beispiel 2a) am höchsten und gleichzeitig die Oberflächenrauhigkeit am niedrigsten ist.

### Vergleichsbeispiel 3

Herstellung einer OLED ohne zweite Elektrodenschicht:
1. Substrate mit metallischen Fingern
   Glassubstrate wurden auf eine Größe von 50 x 50 mm² geschnitten und gereinigt. Danach wurden mit Hilfe einer Schattenmaske Metallfinger aus Silber auf das Substrat gedampft. Die parallelen Metalllinien mit einer Breite von 1 mm und einem Abstand von 5 mm waren über einen senkrecht dazu verlaufenden mittigen Steg verbunden und hatten eine Höhe von 170 nm. Unmittelbar vor dem Beschichten werden die Substratoberflächen mit UV/Ozon (UVP Inc., PR-100) für 15 min gereinigt und aktiviert.
2. Aufbringen einer ersten Elektrodenschicht unter Verwendung einer erfindungsgemäßen PEDT:PSS-Dispersion
   Ca. 2 mL der Dispersion aus Beispiel 1a) wurden auf das Substrat gegeben und anschließend mit einer Lackschleuder bei 1000 U/min bei einer Beschleunigung von 500 U/min/sec für 30 sec auf dem Glassubstrat mit den Metallfingern verteilt. Das Substrat mit der noch feuchten Elektrodenschicht wurde anschließend auf eine Heizplatte gelegt, mit einer Petrischale abgedeckt bei 200°C für 5 min getrocknet. Die Elektrodenschicht war ca. 170 nm dick und hatte eine elektrische Leitfähigkeit von 356 S/cm.
3. Aufbringen der Emitterschicht:
   Ca. 2 mL einer 1 Gew.-% Xylol-Lösung des Emitters Green 1300 LUMATION^{™} - im Folgenden auch als DGP abgekürzt - (Dow Chemical Company) wurden filtriert (Millipore HV, 0,45 µm) und auf der getrockneten ersten Elektrodenschicht verteilt. Die überstehende Lösung des Emitters wurde durch Rotation des Tellers bei 500 U/min bei einer Beschleunigung von 200 U/min/sec für 30 sec lang abgeschleudert. Danach wurde das so beschichtete Substrat 5 min lang bei 110°C auf einer Heizplatte getrocknet. Die Gesamtschichtdicke betrug 250 nm.
4. Aufbringen der Metallkathoden:
   Auf die Emitterschicht wurden Metallelektroden gedampft. Die dafür eingesetzte Aufdampfanlage (Edwards) ist in einer Inertgas-Glovebox (Braun) integriert. Das Substrat wurde mit der Emitterschicht nach unten auf eine Lochmaske gelegt. Die Löcher in der Maske hatten einen Durchmesser von 2,0 mm und einen Abstand von 5,0 mm. Die Maske wurde dabei so positioniert, dass sich die Löcher genau zwischen den Metallfindern befanden. Aus zwei Aufdampfschiffchen wurden bei einem Druck von p = 10-3 Pa nacheinander eine 5 nm dicke Ba-Schicht und anschließend eine 200 nm Ag-Schicht aufgedampft. Die Aufdampfraten betrugen 10 Å/sec für Ba und 20 Å/sec für Ag.
5. Charakterisierung der OLEDs:
   Zur elektrooptischen Charakterisierung wurden die beiden Elektroden der OLED über elektrische Zuführungen mit einer Spannungsquelle verbunden. Der positive Pol wurde mit den Metallfingern, der negative Pol mit einer der aufgedampften, runden Metall-Elektroden verbunden.
   Die Abhängigkeit des OLED-Stroms und der Elektrolumineszenzintensität (EL) von der Spannung wurden aufgezeichnet (Stromspannungsquelle Keithley2400). Der Nachweis der EL erfolgte mit einer Photodiode (EG&G C30809E) mit nachgeschaltetem Elektrometer (Keithley 6514), die Kalibrierung der Leuchtdichte mit einem Luminanzmeter (Minolta LS-100).

### Beispiel 4

### Herstellung einer erfindungsgemäßen OLED mit erster und zweiter Elektrodenschicht:

Die Durchführung erfolgte wie unter Beispiel 3, mit der Abweichung, dass zwischen Schritt 2 und 3 eine zweite Elektrodehschicht aus PEDT:PSS aufgebracht wurde. Dazu wurden auf die getrocknete erste Elektrodenschicht 2 mL einer wässrigen PEDT:PSS-Dispersion (Baytron^{®} P CH8000 der H.C. Starck GmbH, PEDT:PSS-Gewichtsverhältnis 1:20, Feststoffgehalt ca. 2,5 Gew.-%, Viskosität ca. 12 mPas bei 700 s⁻¹ bei 20°C), die zuvor filtriert wurde (Millipore HV, 0,45 µm) mit einer Lackschleuder bei 1000 U/min bei einer Beschleunigung von 200 U/min/sec für 30 sec verteilt. Das Substrat mit der noch feuchten zweiten Elektrodenschicht wurde anschließend auf eine Heizplatte gelegt, mit einer Petrischale abgedeckt und bei 200°C für 5 min getrocknet. Die beiden Elektrodenschichten hatten zusammen eine Schichtdicke von 270 nm.

**Tab. 2: OLED-Strom I, Leuchtdichte L und Effizienz η der OLEDs aus Beispiel 3 und 4**

| | **4V** | | | **8V** | | |
|---|---|---|---|---|---|---|
| | **I [mA/cm²]** | **L [cd/m²]** | **η [cd/A]** | **I [mA/cm²]** | **L [cd/m²]** | **η [cd/A]** |
| **Beispiel 4** | 7.0 | 19 | 0.27 | 385.4 | 7230 | 1.88 |
| **Beispiel 3** | 18.9 | 660 | 3.48 | 503.2 | 20148 | 4.00 |

Der Vergleich zeigt, dass die erfindungsgemäße OLED aus Beispiel 4 mit der zweischichtigen Elektrode im relevanten Spannungsbereich überraschend eine deutlich höhere Leuchtdichte L und Effizienz η aufweist als die OLED aus Beispiel 3 mit der lediglich einschichtigen Elektrode.

### Vergleichsbeispiel 5

Die Durchführung erfolgte wie im Beispiel 3 beschrieben, mit folgender Abweichung in den Schichtdicken:
Deviceaufbau:
   Metallfinger// erste Elektrodenschicht (75nm)// DGP (80nm)// Ba// Ag

### Beispiel 6 (erfindungsgemäß)

Die Durchführung erfolgte wie im Beispiel 4 beschrieben, mit folgender Abweichung in den Schichtdicken:
Deviceaufbau:
   Metallfinger// erste Elektrodenschicht (75nm)// zweite Elektrodenschicht (80nm)// DGP (80nm)// Ba// Ag

### Vergleichsbeispiel 7

Die Durchführung erfolgte wie im Beispiel 5, mit folgender Abweichung: Anstelle der Dispersion aus Beispiel 1a) wird zur Herstellung der ersten Elektrodenschicht eine Dispersion aus Beispiel 1b) verwendet.
Deviceaufbau:
   Metallfinger// erste Elektrodenschicht (80nm)// DGP (80nm)// Ba// Ag

### Vergleichsbeispiel 8

Die Durchführung erfolgte wie im Beispiel 6, mit folgender Abweichung: Anstelle der Dispersion aus Beispiel 1a) wird zur Herstellung der ersten Elektrodenschicht eine Dispersion aus Beispiel 1b) verwendet.
Deviceaufbau:
   Metallfinger// erste Elektrodenschicht (80nm)// zweite Elektrodenschicht (80nm)// DGP (80nm)// Ba//Ag

Die Charakterisierung der OLEDs erfolgte wie unter Beispielen 3 und 4 beschrieben.

**Tab. 3: OLED-Strom I, Leuchtdichte L und Effizienz η der OLEDs aus Beispielen 5 bis 8:**

| | **4V** | | | | **8V** | | | |
|---|---|---|---|---|---|---|---|---|
| | **I [mA/cm**²] | **L [cd/m²**] | **η [cd/A]** | **I+/I-** | **I [mA/cm²**] | **L [cd/m²**] | **η [cd/A]** | **I+/I-** |
| **Beispiel 5** | 28.6 | 128 | 0.45 | 1.40E+01 | 524.5 | 9052 | 1.73 | 1.84E+01 |
| **Beispiel 6** | 21.4 | 1300 | 6.07 | 3.50E+05 | 477.6 | 25730 | 5.39 | 7.09E+04 |
| **Beispiel 7** | 17.1 | 138 | 0.80 | 4.20E+00 | 500.0 | 18600 | 3.72 | 7.42E+00 |
| **Beispiel 8** | 25.7 | 1628 | 6.33 | 4.20E+01 | 383.7 | 21700 | 5.66 | 1 .88E+01 |

Der Vergleich zeigt wiederum, dass die erfindungsgemäße OLED aus Beispiel 6 mit der zweischichtigen Elektrode im relevanten Spannungsbereich überraschend eine deutlich höhere Leuchtdichte L und Effizienz η aufweist als die OLEDs aus den Vergleichsbeispielen 5 und 7 mit der lediglich einschichtigen Elektrode. Zudem zeigt der Vergleich, dass die erfindungsgemäße OLED aus Beispiel 6 mit der zweischichtigen Elektrode, die mit der erfindungsgemäßen Dispersion hergestellt wurde, ein sehr viel höheres Gleichrichtungsverhältnis (I+/I-) aufweist als die OLED mit der zweischichtigen Elektrode aus Vergleichsbeispiel 8.

## Patentansprüche

1. Verfahren zur Herstellung einer Elektrode enthaltend wenigstens zwei Schichten, **dadurch gekennzeichnet, dass**
• eine erste Schicht hergestellt wird, indem eine wässrige Dispersion enthaltend wenigstens ein polymeres Anion und wenigstens ein gegebenenfalls substituiertes Polythiophen enthaltend wiederkehrende Einheiten der allgemeinen Formel (I), 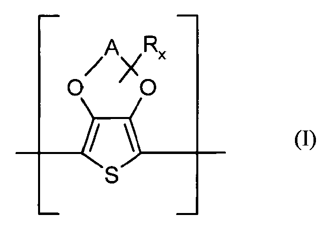 worin
A für einen gegebenenfalls substituierten C₁-C₅-Alkylenrest steht,
R für einen linearen oder verzweigten, gegebenenfalls substituierten C₁-C₁₈-Alkylrest, einen gegebenenfalls substituierten C₅-C₁₂-Cycloalkylrest, einen gegebenenfalls substituierten C₆-C₁₄-Arylrest, einen gegebenenfalls substituierten C₇-C₁₈-Aralkylrest, einen gegebenenfalls substituierten C₁-C₄-Hydroxyalkylrest oder einen Hydroxylrest steht,
x für eine ganze Zahl von 0 bis 8 steht und
für den Fall, dass mehrere Reste R an A gebunden sind, diese gleich oder unterschiedlich sein können,
und in der Dispersion 50 Gew.-% der Partikel kleiner als 50 nm sind,
auf ein geeignetes Substrat aufgebracht und danach verfestigt wird, und anschließend
• eine zweite Schicht hergestellt wird, indem eine wässrige Dispersion enthaltend wenigstens ein gegebenenfalls substituiertes Polythiophen enthaltend wiederkehrende Einheiten der allgemeinen Formel (II-a) und/oder (II-b) 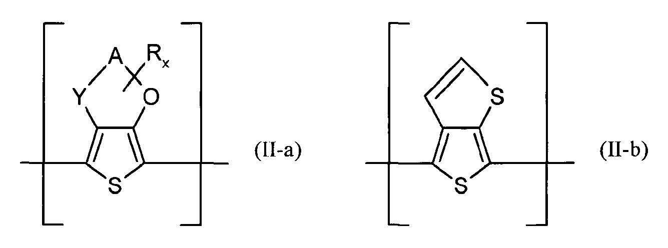 worin
A für einen gegebenenfalls substituierten C₁-C₅-Alkylenrest steht,
Y für O oder S steht,
R für einen linearen oder verzweigten, gegebenenfalls substituierten C₁-C₁₈-Alkylrest, einen gegebenenfalls substituierten C₅-C₁₂-Cycloalkylrest, einen gegebenenfalls substituierten C₆-C₁₄-Arylrest, einen gegebenenfalls substituierten C₇-C₁₈-Aralkylrest, einen gegebenenfalls substituierten C₁-C₄-Hydroxyalkylrest oder einen Hydroxylrest steht,
x für eine ganze Zahl von 0 bis 8 steht und
für den Fall, dass mehrere Reste R an A gebunden sind, diese gleich oder unterschiedlich sein können, und wenigstens ein polymeres Anion, auf die erste Schicht aufgebracht und anschließend verfestigt wird.

2. Verfahren gemäß Anspruch 1, **dadurch gekennzeichnet, dass** die Dispersion zur Herstellung der ersten Schicht wenigstens 0,1 Gew.-%, bezogen auf das Gesamtgewicht der Dispersion, eines oder mehrerer Additive ausgewählt aus der Gruppe ethergruppenhaltiger Verbindungen, lactongruppenhaltiger Verbindungen, amid- oder lactamgruppenhaltiger Verbindungen, Sulfonen, Sulfoxiden, Zuckern oder Zuckerderivaten, Zuckeralkoholen, Furanderivaten und Di- oder Polyalkoholen enthält.

3. Verfahren gemäß Anspruch 1 oder 2, **dadurch gekennzeichnet, dass** in Formel (I) für die widerkehrenden Einheiten des Polythiophens in der ersten Schicht unabhängig voneinander A für einen gegebenenfalls substituierten C₂-C₃-Alkylenrest und x für 0 oder 1 steht.

4. Verfahren gemäß wenigstens einem der Ansprüche 1 bis 3, **dadurch gekennzeichnet, dass** das Polythiophen enthaltend wiederkehrende Einheiten der allgemeinen Formel (I) Poly(3,4-ethylendioxythiophen) ist.

5. Verfahren gemäß wenigstens einem der Ansprüche 1 bis 4, **dadurch gekennzeichnet, dass** das polymere Anion ein Anion einer polymeren Carbon- oder Sulfonsäure, bevorzugt der Polystyrolsulfonsäure ist.

6. Verfahren gemäß wenigstens einem der Ansprüche 1 bis 5, **dadurch gekennzeichnet, dass** das oder die gegebenenfalls substituierte(n) Polythiophen(e) enthaltend wiederkehrende Einheiten der allgemeinen Formel (I) und das oder die polymere(n) Anion(en) in der ersten Schicht in einem Gewichtsverhältnis von 0.5:1 bis 20:1 vorliegen.

7. Verfahren gemäß Anspruch 1, **dadurch gekennzeichnet, dass** Polythiophen enthaltend wiederkehrende Einheiten der allgemeinen Formel (II-a) und/oder (II-b) Poly(3,4-ethylendioxythiophen) ist.

## Claims

1. Process for producing an electrode containing at least two layers, **characterized in that**
• a first layer is produced by applying an aqueous dispersion containing at least one polymeric anion and at least one optionally substituted polythiophene containing repeating units of the general formula (I), 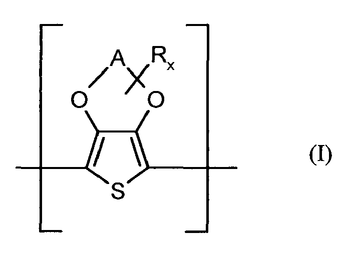 wherein
A represents an optionally substituted C₁ to C₅ alkylene radical,
R represents a linear or branched, optionally substituted C₁ to C₁₈ alkyl radical, an optionally substituted C₅ to C₁₂ cycloalkyl radical, an optionally substituted C₆ to C₁₄ aryl radical, an optionally substituted C₇ to C₁₈ aralkyl radical, an optionally substituted C₁ to C₄ hydroxyalkyl radical or a hydroxyl radical,
x represents a whole number from 0 to 8 and in the case that several radicals R are bound to A, they can be the same or different,
and 50 wt. % of particles in the dispersion are smaller than 50 nm,
to a substrate and is subsequently solidified, and subsequently
• a second layer is produced by applying an aqueous dispersion containing at least one optionally substituted polythiophene containing repeating units of the general formula (II-a) and/or (II-b) 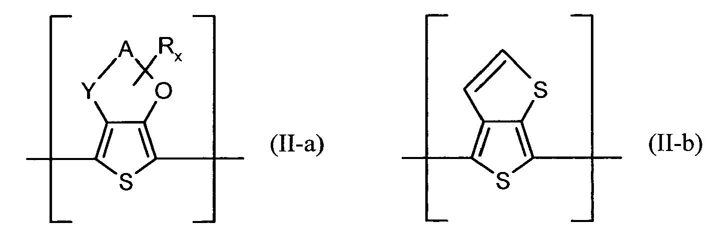 wherein
A represents an optionally substituted C₁ to C₅ alkylene radical,
Y represents O or S,
R represents a linear or branched, optionally substituted C₁ to C₁₈ alkyl radical, an optionally substituted C₅ to C₁₂ cycloalkyl radical, an optionally substituted C₆ to C₁₄ aryl radical, an optionally substituted C₇ to C₁₈ aralkyl radical, an optionally substituted C₁ to C₄ hydroxyalkyl radical or a hydroxyl radical,
x represents a whole number from 0 to 8 and in the case that several radicals R are bound to A, they can be the same or different,
and at least one polymeric anion is applied onto the first layer and is subsequently solidified.

2. Process according to claim 1, **characterized in that** the dispersion for the preparation of the first layer contains at least 0.1 wt. %, based on the total weight of the dispersion, of one or more additives selected from the group of ether group-containing compounds, lactone group-containing compounds, amide group-containing compounds, lactam group-containing compounds, sulfones, sulfoxides, sugars, sugar derivatives, sugar alcohols, furan derivatives and di- or polyalcohols.

3. Process according to claim 1 or 2, **characterized in that** in formula (I) for the repeating units of the polythiophenes in the first layer independently from each other A represents an optionally substituted C₂ to C₃ alkylene radical and x represents 0 or 1.

4. Process according to at least one of claims 1 to 3, **characterized in that** the polythiophene containing repeating units of the general formula (I) is poly(3,4-ethylenedioxythiophene).

5. Process according to at least one of claims 1 to 4, **characterized in that** the at least one polymeric anion is an anion of a polymeric carboxylic or sulfonic acid, preferably polystyrene sulfonic acid.

6. Process according to at least one of claims 1 to 5, **characterized in that** the optionally substituted polythiophene(s) containing repeating units of the general formula (I) and the polymeric anion(s) are present in the first layer in a ratio by weight of 0.5 : 1 to 20 : 1.

7. Process according to claim 1, **characterized in that** the polythiophene containing repeating units of general formula (II-a) and/or (II-b) is poly(3,4-ethylenedioxythiophene).

## Revendications

1. Procédé de fabrication d'une électrode comprenant au moins deux couches, **caractérisé en ce que**
• une première couche est fabriquée en procédant au dépôt sur un substrat approprié, puis à la solidification d'une dispersion aqueuse comprenant au moins un anion polymérique et au moins un polythiophène éventuellement substitué comprenant des motifs répétitifs de formule générale (I), 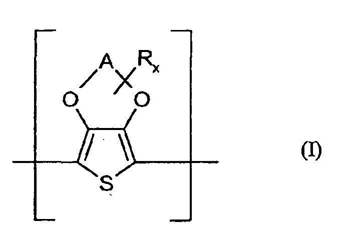 dans laquelle
A représente un radical alkylène en C₁-C₅ éventuellement substitué,
R représente un radical alkyle en C₁-C₁₈ éventuellement substitué, linéaire ou ramifié, un radical cycloalkyle en C₅-C₁₂ éventuellement substitué, un radical aryle en C₆-C₁₄ éventuellement substitué, un radical aralkyle en C₇-C₁₈ éventuellement substitué, un radical hydroxyalkyle en C₁-C₄ éventuellement substitué ou un radical hydroxyle,
x représente un nombre entier compris entre 0 et 8, et
dans le cas où plusieurs radicaux R sont liés à A, ceux-ci peuvent être identiques ou différents,
et dans la dispersion, 50 % en poids des particules sont inférieures à 50 nm, et ensuite
• une deuxième couche est fabriquée en procédant au dépôt sur la première couche, puis à la solidification d'une dispersion aqueuse comprenant au moins un polythiophène éventuellement substitué comprenant des motifs répétitifs de formule générale (II-a) et/ou (II-b), 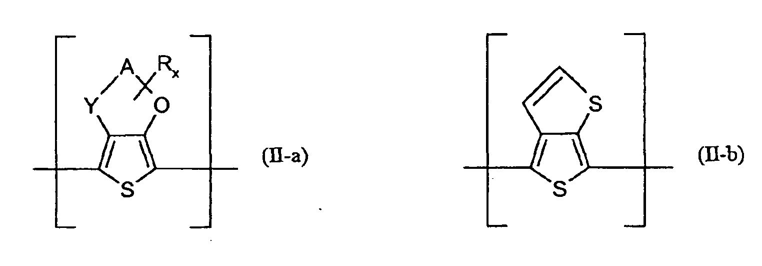 dans lesquelles
A représente un radical alkylène en C₁-C₅ éventuellement substitué,
Y représente O ou S,
R représente un radical alkyle en C₁-C₁₈ éventuellement substitué, linéaire ou ramifié, un radical cycloalkyle en C₅-C₁₂ éventuellement substitué, un radical aryle en C₆-C₁₄ éventuellement substitué, un radical aralkyle en C₇-C₁₈ éventuellement substitué, un radical hydroxyalkyle en C₁-C₄ éventuellement substitué ou un radical hydroxyle,
x représente un nombre entier compris entre 0 et 8, et
dans le cas où plusieurs radicaux R sont liés à A, ceux-ci peuvent être identiques ou différents,
et au moins un anion polymérique.

2. Procédé selon la revendication 1, **caractérisé en ce que** la dispersion pour la fabrication de la première couche comprend au moins 0,1 % en poids, par rapport au poids total de la dispersion, d'un ou de plusieurs additifs choisis dans le groupe constitué par les composés comprenant des groupements éthers, les composés comprenant des groupements lactones, les composés comprenant des groupements amides ou lactames, les sulfones, les sulfoxydes, les sucres ou dérivés de sucre, les alcools de sucre, les dérivés du furane et les di- ou polyalcools.

3. Procédé selon la revendication 1 ou 2, **caractérisé en ce que**, dans la formule (I) pour les motifs répétitifs du polythiophène dans la première couche, A représente, indépendamment les uns des autres, un radical alkylène en C₂-C₃ éventuellement substitué et x représente 0 ou 1.

4. Procédé selon au moins l'une des revendications 1 à 3, **caractérisé en ce que** le polythiophène comprenant des motifs répétitifs de formule générale I est le poly(éthylène-3,4-dioxythiophène).

5. Procédé selon au moins l'une des revendications 1 à 4, **caractérisé en ce que** l'anion polymérique est un anion d'un acide carboxylique ou sulfonique polymérique, de préférence l'acide polystyrènesulfonique.

6. Procédé selon au moins l'une des revendications 1 à 5, **caractérisé en ce que** le ou les polythiophènes, éventuellement substitués, comprenant des motifs répétitifs de formule générale (I) et le ou les anions polymériques dans la première couche sont présents en un rapport en poids de 0,5/1 à 20/1.

7. Procédé selon la revendication 1, **caractérisé en ce que** le polythiophène comprenant des motifs répétitifs de formule générale (II-a) et/ou (II-b) est le poly(éthylène-3,4-dioxythiophène).
